# EUROPEAN PATENT APPLICATION

(11) **EP 4 790 349 A1**
(43) Date of publication of application: **12.08.2026**
(21) Application number: 26156763.0
(22) Date of filing: 06.02.2026
(51) Int. Cl.: F28D 15/02, F28F 1/02, H05K 7/20, H10W 40/73

(54) **THREE-DIMENSION HEAT TRANSFER DEVICE**

(30) Priority: 07.02.2025 CN 202510138319
(71) Applicant: Purple Cloud Development Pte. Ltd., Singapore 128424 (SG)
(72) Inventor: Lin, Hua-Yuan, Taipei City (TW); Liu, Lei Lei, Hui Zhou City (CN); Zhang, Xiong, Hui Zhou City (CN); Ke, Shao-Hsuan, Taipei City (TW); Ansari, Munib Qasim, Hui Zhou City (CN)
(74) Representative: Grünecker Patent- und Rechtsanwälte PartG mbB

(57) **Abstract**

A three-dimensional heat transfer device configured to be thermally coupled to a heat source. The three-dimensional heat transfer device includes a thermally conductive casing having an airtight chamber and a thermal contact surface, the thermal contact surface faces away from the airtight chamber and is thermally coupled to the heat source, at least one first heat pipe disposed on the thermally conductive casing and in fluid communication with the airtight chamber, and at least one second heat pipe disposed on the thermally conductive casing and in fluid communication with the airtight chamber, wherein a cross-section of the first heat pipe is different from a cross-section of the second heat pipe, and the first heat pipe and the second heat pipe are configured to guide an airflow to a primary cooling area corresponding to the thermal contact surface.

## Description

### TECHNICAL FIELD

The present disclosure is related to the field of a heat transfer device, in particular a three-dimensional heat transfer device.

### BACKGROUND

A vapor chamber functions on the similar technological principle as a heat pipe, but the manner of conduct differs. A heat pipe provides one-dimensional linear heat conduction, but heat in a vapor chamber is conducted in two dimensions, resulting in higher efficiency. Specifically, a vapor chamber comprises primarily a cavity containing a hollow chamber, which is configured to be filled with a working fluid. The heated portion of the cavity is referred as an evaporation region. The portion of cavity responsible for heat dissipation is referred to as a condensation region. The working fluid absorbs heat in the evaporation region, vaporizes, and rapidly expands throughout the cavity. In the condensation region, the working fluid dissipates heat and condenses into liquid. The liquid working fluid subsequently returns to the evaporation region, forming a cooling cycle.

Conventional heat dissipation devices generally utilize vapor chambers or heat pipes independently, resulting in planar or linear heat transfer instead of integrated three-dimensional heat transfer. While vapor chambers and heat pipes have been integrated to develop three-dimensional heat transfer devices, the heat transmission efficiency of such devices is still limited by constraints such as server height restrictions, overall system space limitations, and suboptimal airflow distribution. Furthermore, heat dissipation efficiency decreases with increasing distance from the heat source, therefore fins positioned farther away from the heat source contribute less effectively to overall thermal management. Merely increasing the number of fins does not necessarily improve performance; instead, it is essential to optimize the heat dissipation efficiency of existing fins. Therefore, there is still a demand for three-dimensional heat transfer devices with higher heat dissipation efficiency.

### SUMMARY

The invention is as defined in the appended claims. Aspects of the disclosure provide a three-dimensional heat transfer device configured to be thermally coupled to a heat source. The three-dimensional heat transfer device includes a thermally conductive casing having an airtight chamber and a thermal contact surface, the thermal contact surface faces away from the airtight chamber and is thermally coupled to the heat source, at least one first heat pipe disposed on the thermally conductive casing and in fluid communication with the airtight chamber, and at least one second heat pipe disposed on the thermally conductive casing and in fluid communication with the airtight chamber, wherein a cross-section of the first heat pipe is different from a cross-section of the second heat pipe, and the first heat pipe and the second heat pipe are configured to guide an airflow to a primary cooling area corresponding to the thermal contact surface.

In an embodiment, the thermally conductive casing comprises a first shell member and a second shell member, the second shell member is disposed on the first shell member such that the first shell member and the second shell member together form the airtight chamber, and the first heat pipe and the second heat pipe are disposed on the second shell member of the thermally conductive casing.

In an embodiment, a size of the cross-section of the first heat pipe is different from a size of the cross-section of the second heat pipe.

In an embodiment, an area of the cross-section of the first heat pipe is less than or equal to 80% of an area of the cross-section of the second heat pipe.

In an embodiment, a shape of the cross-section of the first heat pipe can be the same with or different from a shape of the cross-section of the second heat pipe.

In an embodiment, the first heat pipe and the second heat pipe each have an elliptical cross-section with a major axis corresponding to a longest diameter of the elliptical cross-section and a minor axis corresponding to a shortest diameter of the elliptical cross-section, and a ratio of the major axis to the minor axis of the first heat pipe is different from a ratio of the major axis to the minor axis of the second heat pipe.

In an embodiment, the shapes of the cross-sections of the first heat pipe or the second heat pipe are airfoil-shaped, elliptical, or gear-toothed.

In an embodiment, the three-dimensional heat transfer device further includes at least one third heat pipe disposed on the second shell member and in fluid communication with the airtight chamber, wherein a cross-section of the third heat pipe is different from the cross-sections of the first heat pipe and the cross-section of the second heat pipe.

In an embodiment, the third heat pipe is disposed in the primary cooling area corresponding to the thermal contact surface, the first heat pipe and the second heat pipe are plural in number and are respectively located on opposite sides of the third heat pipe, and the second heat pipes on the same side with the first heat pipes, relative to the third heat pipe, are disposed between the first heat pipes and the third heat pipe.

In an embodiment, each of the first heat pipes, the second heat pipes, and the at least one third heat pipe has an elliptical cross-section with a major axis corresponding to a longest diameter and a minor axis corresponding to a shortest diameter, and wherein a ratio of the major axis to the minor axis of the first heat pipes exceeds a ratio of the major axis to the minor axis of the second heat pipes, and the ratio of the major axis to the minor axis of the second heat pipes exceeds a ratio of the major axis to the minor axis of the at least one third heat pipe.

In an embodiment, the three-dimensional heat transfer device further includes a plurality of third heat pipes, a plurality of fourth heat pipes, and a plurality of fifth heat pipes, wherein the first heat pipes to the fifth heat pipes are arranged in sequence, and sizes of cross-sections of the first heat pipes to the fifth heat pipes gradually increase in sequence.

### BRIEF DESCRIPTION OF DRAWINGS

Aspects of the present disclosure can be understood from the following detailed description when read with the accompanying figures. It is noted that, in accordance with the standard practice in the industry, various features are not drawn to scale. In fact, the dimensions of the various features may be increased or reduced for clarity of discussion.
FIG. 1 is a perspective view of a three-dimensional heat transfer device 10 according to a first embodiment of the present disclosure.
FIG. 2 is an exploded view of the three-dimensional heat transfer device 10 of FIG. 1.
FIG. 3 is a cross-sectional view of the heat pipes of the three-dimensional heat transfer device 10 of FIG. 1.
FIG. 4 is a perspective view of a three-dimensional heat transfer device 10A according to a second embodiment of the present disclosure.
FIG. 5 is a cross-sectional view of the heat pipes of the three-dimensional heat transfer device 10A of FIG. 4.
FIG. 6 is a perspective view of a three-dimensional heat transfer device 10D according to a third embodiment of the present disclosure.
FIG. 7 is a cross-sectional view of the heat pipes of the three-dimensional heat transfer device 10D of FIG. 6.
FIG. 8 is a perspective view of a three-dimensional heat transfer device 10E according to a fourth embodiment of the present disclosure.
FIG. 9 is a cross-sectional view of the heat pipes of the three-dimensional heat transfer device 10E of FIG. 8.

### DETAILED DESCRIPTION

Detailed descriptions and technical contents of the present invention are illustrated below in conjunction with the accompanying drawings. However, it is to be understood that the descriptions and the accompanying drawings disclosed herein are merely illustrative and exemplary and not intended to limit the scope of the present invention.

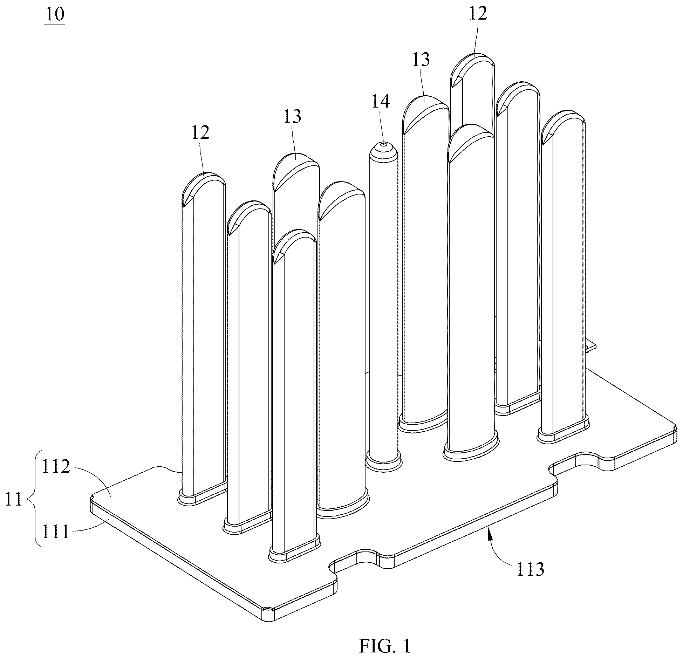

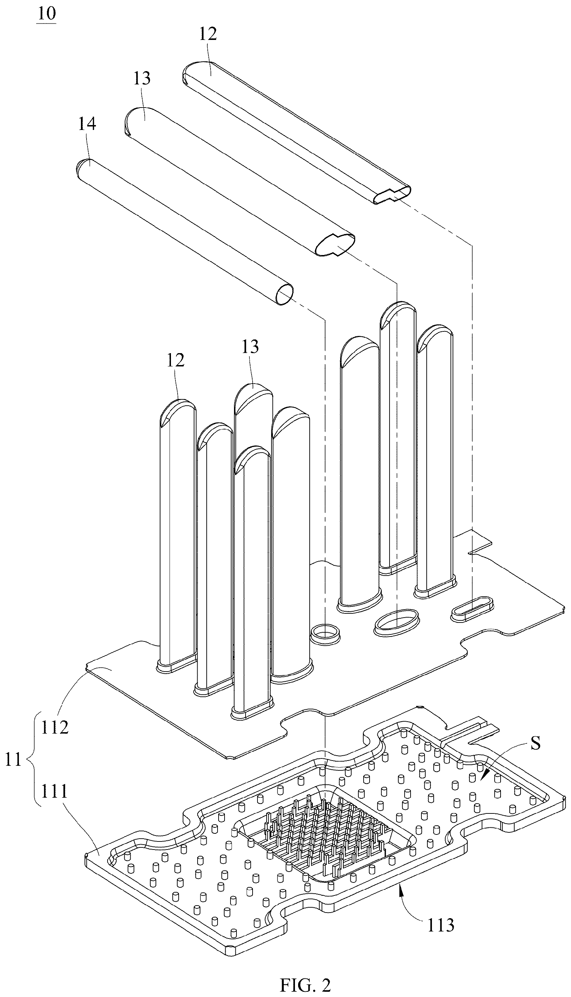

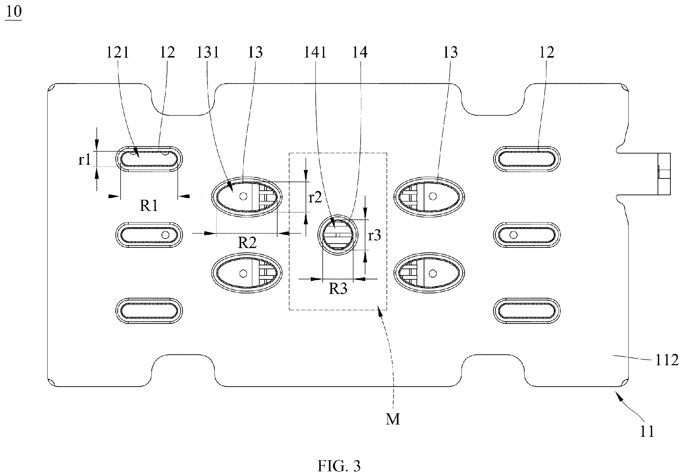

Please refer to FIGS. 1 to 3. FIG. 1 is a perspective view of a three-dimensional heat transfer device 10 according to a first embodiment of the present disclosure. FIG. 2 is an exploded view of the three-dimensional heat transfer device 10 of FIG. 1. FIG. 3 is a cross-sectional view of the heat pipes of the three-dimensional heat transfer device 10 of FIG. 1.

The three-dimensional heat transfer device 10 is configured to be thermally coupled to a heat source (not shown). The term "thermally coupled" refers to thermal contact or connection through other heat-conducting media. The three-dimensional heat transfer device 10 includes a thermally conductive casing 11, a plurality of first heat pipes 12, a plurality of second heat pipes 13, and a third heat pipe 14. The thermally conductive casing 11 includes a first shell member 111 and a second shell member 112. The second shell member 112 is disposed on the first shell member 111 such that the first shell member 111 and the second shell member 112 together form an airtight chamber S. The first shell member 111 includes a thermal contact surface 113 that faces away from the airtight chamber S. The thermal contact surface 113 is configured to be thermally coupled to the heat source.

The first heat pipes 12, the second heat pipes 13, and the third heat pipe 14 are parallel disposed on the second shell member 112 and are in fluid communication with the airtight chamber S. The third heat pipe 14 may be disposed in the center of the second shell member 112. The first heat pipes 12 and the second heat pipes 13 may be respectively disposed on opposite sides of the third heat pipe 14. On either side of the third heat pipe 14, the second heat pipes 13 are disposed between the first heat pipes 12 and the third heat pipe 14.

As shown in FIG. 3, the cross-sections 121 of the first heat pipes 12 relative to the second shell member 112, the cross-sections 131 of the second heat pipes 13 relative to the second shell member 112, and the cross-section 141 of the third heat pipe 14 relative to the second shell member 112 are different. For example, the shapes of the cross-sections 121 of the first heat pipes 12 and the cross-sections 131 of the second heat pipes 13 are elliptical, and the shape of the cross-section 141 of the third heat pipe 14 is circular. Furthermore, the differences of the cross-sections 121 of the first heat pipes 12 and the cross-sections 131 of the second heat pipes 13 are detailed below.

Each cross-section 121, 131, 141 has a major axis R1, R2, R3 and a minor axis r1, r2, r3. The ratio of R1/r1 in each cross-section 121 of the first heat pipes 12 is greater than the ratio of R2/r2 in each cross-section 131 of the second heat pipes 13. Further, the ratio of R2/r2 in each cross-section 131 of the second heat pipes 13 is greater than the ratio of R3/r3 in the cross-section 141 of the third heat pipe 14. That is, the cross-sections 121 is flatter than the cross-sections 131, and the cross-sections 131 is flatter than the cross-section 141.

The first heat pipes 12, the second heat pipes 13, and the third heat pipe 14 are configured to guide airflow to a primary cooling area M. The primary cooling area M is defined as a region on the second shell member 112 that is aligned with, or positioned within a projected area of, the thermal contact surface 113 when viewed in a direction perpendicular to the second shell member 112. In particular, the primary cooling area M corresponds to a region where the heat source generates greater heat compared to surrounding areas of the heat source. The third heat pipe 14 is positioned within the primary cooling area M such that thermal energy concentrated in this higher temperature region can be efficiently absorbed by the working fluid within the third heat pipe 14 and subsequently dissipated through the heat pipe structure. By strategically positioning the heat pipes 12, 13, and 14 with varying cross-sectional configurations, the airflow is directed preferentially toward the primary cooling area M, enhancing heat transfer efficiency in the region of greatest thermal demand.

In this embodiment, the advantage of having different flatness for the cross-sections 121, 131, 141 is that the shape differences among the heat pipes 12, 13, 14 can change the direction in which airflow flows through the heat pipes 12, 13, 14. For example, when the airflow flows through the primary cooling area M, it is easy to produce turbulent airflow to enhance heat exchange efficiency. As a result, the heat dissipation efficiency of the three-dimensional heat transfer device 10 can be improved.

In this embodiment, the three-dimensional heat transfer device 10 may further include a plurality of fins (not shown). The fins can be arranged along the cross-sectional direction of the heat pipes 12, 13, and 14, but are not limited thereto. By providing the fins and guiding the airflow to the primary cooling area M through the shape, number, and position of the heat pipes 12, 13, and 14, the heat generated by heat source can be efficiently dissipated. As a result, the heat dissipation efficiency of the fins of the three-dimensional heat transfer device 10 can be further improved.

In this embodiment, the number of first heat pipes 12 and the number of second heat pipes 13 are plural, and the number of third heat pipes 14 is single, but are not limited thereto. In other embodiments, the number of first heat pipes and the number of second heat pipes may also be single, and the number of third heat pipes may also be plural.

In this embodiment, the shapes of the cross-sections 121 of the first heat pipes 12 and the cross-sections 131 of the second heat pipes 13 are elliptical, and the shape of the cross-section 141 of the third heat pipe 14 is circular, but are not limited thereto. In other embodiments, the shapes of the cross-sections of the first heat pipes, the cross-sections of the second heat pipes, and the cross-section of the third heat pipe may also be airfoil-shaped or gear-toothed. In some embodiments, the cross-sections of the first heat pipes, second heat pipes, and third heat pipes can be the same.

In this embodiment, the primary cooling area M corresponds to the thermal contact surface 113, but is not limited thereto. In other embodiments, the primary cooling area may correspond to a surface other than the thermal contact surface.

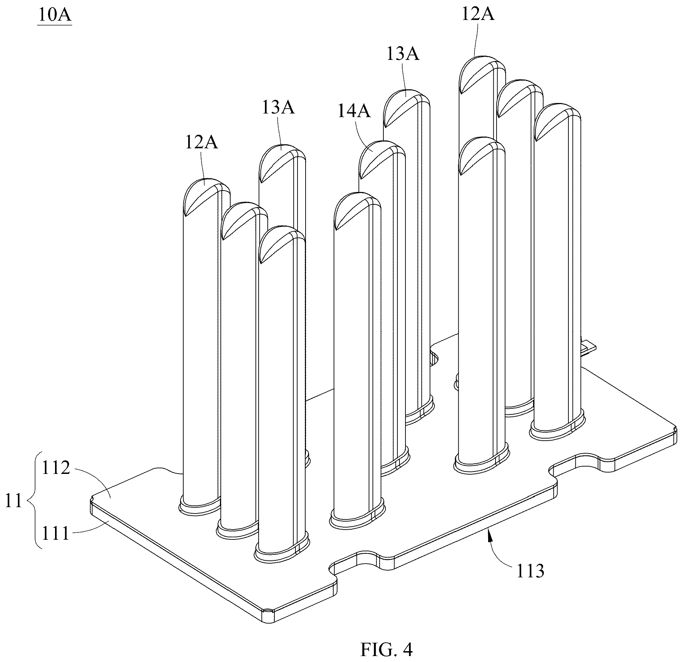

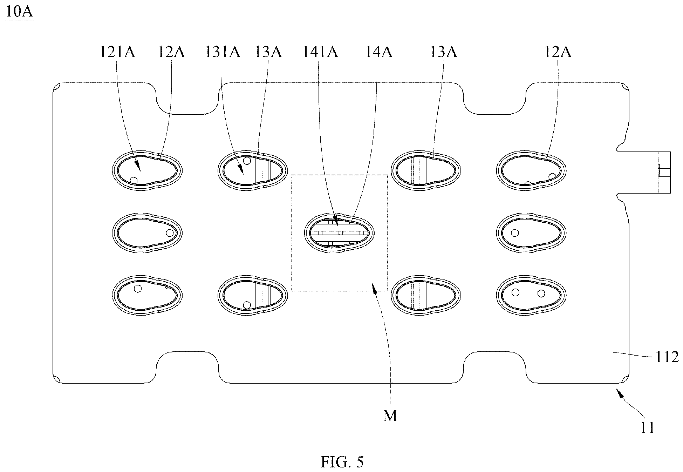

Referring to FIGS. 4 and 5. FIG. 4 is a perspective view of a three-dimensional heat transfer device 10A according to a second embodiment of the present disclosure. FIG. 5 is a cross-sectional view of the heat pipes of the three-dimensional heat transfer device 10A of FIG. 4.

Elements of the three-dimensional heat transfer device 10A similar to those of the first embodiment are designated with like reference numerals, and detailed descriptions thereof are omitted for brevity. The three-dimensional heat transfer device 10A includes a thermally conductive casing 11, a plurality of first heat pipes 12A, a plurality of second heat pipes 13A, and a third heat pipe 14A. The thermally conductive casing 11 includes a first shell member 111 and a second shell member 112, wherein the second shell member 112 is mounted on the first shell member 111.

The first heat pipes 12A, the second heat pipes 13A, and the third heat pipe 14A are disposed on the second shell member 112. The first heat pipes 12A and the second heat pipes 13A can be respectively disposed on opposite sides of the third heat pipe 14A. On either side of the third heat pipe 14A, the second heat pipes 13A are disposed between the first heat pipes 12A and the third heat pipe 14A.

As shown in FIG. 5, the cross-sections 121A of the first heat pipes 12A relative to the second shell member 112, the cross-sections 131A of the second heat pipes 13A relative to the second shell member 112, and the cross-section 141A of the third heat pipe 14A relative to the second shell member 112 are the same. For example, the shapes of the cross-sections 121A, the cross-sections 131A, and the cross-section 141A are airfoil-shaped.

In this embodiment, the airfoil-shaped cross-sections 121A, 131A, 141A provide improved aerodynamic performance when airflow flows through the main cooling area M. The streamlined airfoil profile reduces the overall cross-sectional area of the heat pipes 12A, 13A, 14A facing the airflow direction, thereby reducing wind resistance compared to conventional circular or elliptical cross-sections. This reduced wind resistance allows the airflow to pass more smoothly through the fin assembly, enhancing convective heat transfer between the airflow and the heat pipe surfaces. In conventional three-dimensional vapor chamber devices with multiple vertically arranged heat pipes having circular cross-sections, the excessive overall frontal area creates high wind resistance that impedes airflow penetration through the fin assembly, resulting in poor heat exchange efficiency. By minimizing frontal drag while maintaining adequate surface area for heat transfer, the airfoil-shaped heat pipes 12A, 13A, 14A improve the heat exchange efficiency and overall heat dissipation performance of the three-dimensional heat transmission device 10A.

The first heat pipes 12A, the second heat pipes 13A, and the third heat pipe 14A can guide airflow to a primary cooling area M corresponding to the thermal contact surface 113. The primary cooling area M corresponds to a region where the heat source generates greater heat compared to surrounding areas of the heat source. The third heat pipe 14A is positioned within the primary cooling area M such that thermal energy concentrated in this higher temperature region can be efficiently absorbed by the working fluid within the third heat pipe 14A and subsequently dissipated through the heat pipe structure.

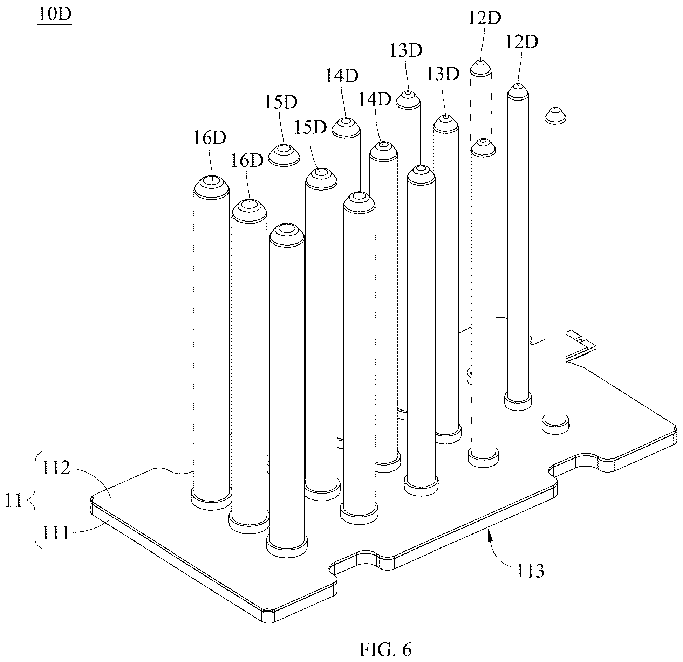

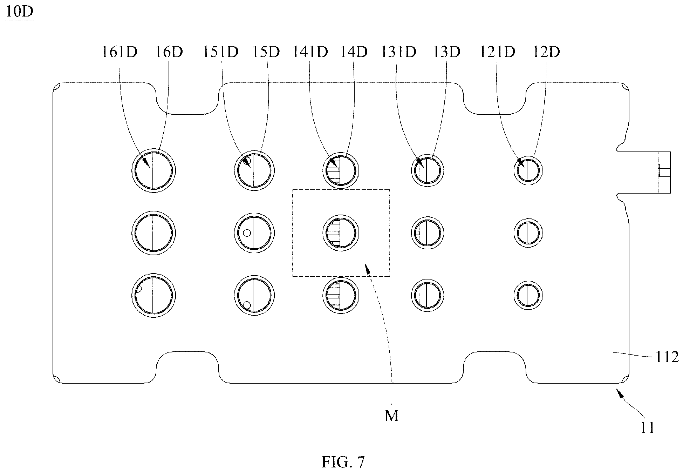

Referring to FIGS. 6 and 7. FIG. 6 is a perspective view of a three-dimensional heat transfer device 10D according to a third embodiment of the present disclosure. FIG. 7 is a cross-sectional view of the heat pipes of the three-dimensional heat transfer device 10D of FIG. 6.

Elements of the three-dimensional heat transfer device 10D similar to those of the first embodiment are designated with like reference numerals, and detailed descriptions thereof are omitted for brevity. The three-dimensional heat transfer device 10D includes a thermally conductive casing 11, a plurality of first heat pipes 12D, a plurality of second heat pipes 13D, a plurality of third heat pipes 14D, a plurality of fourth heat pipes 15D, and a plurality of fifth heat pipes 16D. The thermally conductive casing 11 includes a first shell member 111 and a second shell member 112. The second shell member 112 is mounted on the first shell member 111.

The first heat pipes 12D to the fifth heat pipes 16D are disposed on the second shell member 112 and are arranged in sequence. The diameters of the cross-sections 121D, 131D, 141D, 151D, and 161D of the first heat pipes 12D, second heat pipes 13D, third heat pipes 14D, fourth heat pipes 15D, and fifth heat pipe 16D respectively, relative to the second shell member 112, are different.

For example, the cross-sections 121D through 161D of the first through fifth heat pipes 12D-16D progressively increase in size sequentially. Specifically, the cross-sectional area of the first heat pipe cross-sections 121D is less than or equal to 80% of the cross-sectional area of the second heat pipe cross-sections 131D. The cross-sectional area of the second heat pipe cross-sections 131D is less than or equal to 80% of the cross-sectional area of the third heat pipe cross-sections 141D. The cross-sectional area of the third heat pipe cross-sections 141D is less than or equal to 80% of the cross-sectional area of the fourth heat pipe cross-sections 151D. The cross-sectional area of the fourth heat pipe cross-sections 151D is less than or equal to 80% of the cross-sectional area of the fifth heat pipe cross-sections 161D. This graduated size arrangement enhances the heat dissipation efficiency of the three-dimensional heat transfer device 10D.

The first heat pipes 12D to the fifth heat pipes 16D can guide airflow to a primary cooling area M corresponding to the thermal contact surface 113. The primary cooling area M corresponds to a region where the heat source generates greater heat compared to surrounding areas of the heat source. Some of the third heat pipes 14D are located in the primary cooling area M to dissipate heat from the primary cooling area M.

In this embodiment, the cross-sections of the first heat pipes 12D to the fifth heat pipes 16D gradually increase in sequence, but are not limited thereto. In other embodiments, the cross-sections of the first heat pipes to the fifth heat pipes may also increase from opposite ends of the second shell member toward the center of the second shell member.

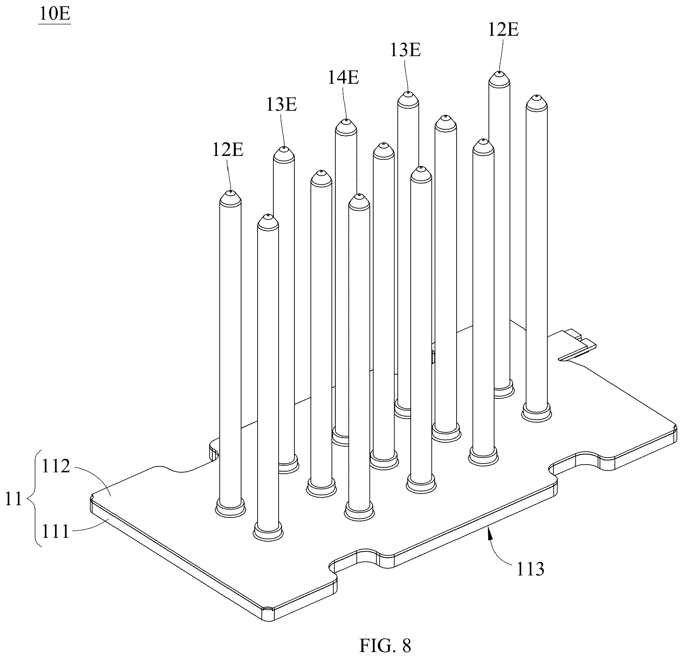

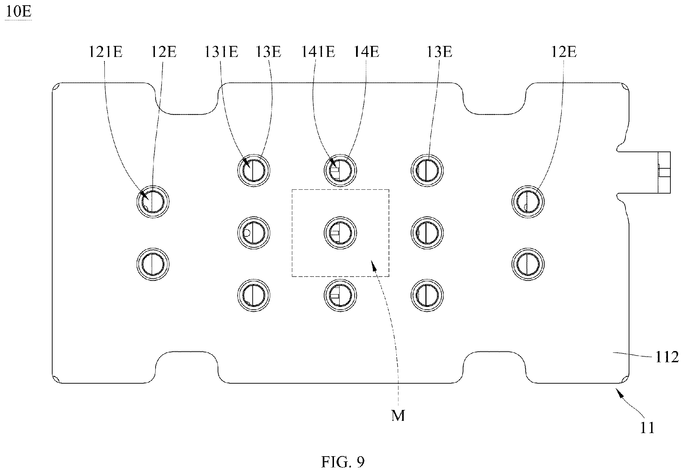

Referring to FIGS. 8 and 9. FIG. 8 is a perspective view of a three-dimensional heat transfer device 10E according to a fourth embodiment of the present disclosure. FIG. 9 is a cross-sectional view of the heat pipes of the three-dimensional heat transfer device 10E of FIG. 8.

Elements of the three-dimensional heat transfer device 10E similar to those of the first embodiment are designated with like reference numerals, and detailed descriptions thereof are omitted for brevity. The three-dimensional heat transfer device 10E includes a thermally conductive casing 11, a plurality of first heat pipes 12E, a plurality of second heat pipes 13E, and a third heat pipe 14E. The thermally conductive casing 11 includes a first shell member 111 and a second shell member 112, wherein the second shell member 112 is mounted on the first shell member 111.

The first heat pipes 12E, the second heat pipes 13E, and the third heat pipe 14E are disposed on the second shell member 112. The first heat pipes 12E and the second heat pipes 13E are respectively located on opposite sides of the third heat pipe 14E. The second heat pipes 13E are disposed between the first heat pipes 12E and the third heat pipe 14E.

The cross-sections 121E of the first heat pipes 12E relative to the second shell member 112, the cross-sections 131E of the second heat pipes 13E relative to the second shell member 112, and the cross-section 141E of the third heat pipe 14E relative to the second shell member 112 have substantially the same shape and size. The shapes of the cross-sections 121E, 131E, and 141E are circular.

The first heat pipes 12E, the second heat pipes 13E, and the third heat pipe 14E are configured to guide airflow to a primary cooling area M. The primary cooling area M is defined as a region on the second shell member 112 that is aligned with, or positioned within a projected area of, the thermal contact surface 113 when viewed in a direction perpendicular to the second shell member 112. The primary cooling area M corresponds to a region where the heat source generates greater heat compared to surrounding areas of the heat source. At least one of the third heat pipes 14E is positioned within the primary cooling area M such that thermal energy concentrated in this higher temperature region can be efficiently absorbed by the working fluid within the third heat pipe 14E and subsequently dissipated through the heat pipe structure.

In this embodiment, the second heat pipes 13E and the third heat pipes 14E are arranged with increased density within and proximate to the primary cooling area M. Stated differently, the heat pipe arrangement density is higher in the higher temperature region of the three-dimensional heat transfer device 10E compared to lower temperature regions. This concentrated arrangement enables the working fluid to undergo more intense heat exchange within the airtight chamber S and the heat pipes located in the higher temperature region, while reducing the amount of working fluid that flows to lower temperature regions for heat exchange. Consequently, the cooling cycle path of the working fluid within the three-dimensional heat transfer device 10E is shortened, thereby improving the heat dissipation efficiency of the three-dimensional heat transfer device 10E.

According to the three-dimensional heat transfer device of the above embodiments, since the cross-sections of the heat pipes relative to the thermally conductive casing are different, and the airflow is guided to the primary cooling area corresponding to the thermal contact surface through the heat pipes, the airflow can more efficiently flow through the higher temperature regions of the three-dimensional heat transfer device, thereby improving heat exchange efficiency. As a result, the heat dissipation efficiency of the three-dimensional heat transfer device can be enhanced.

Therefore, embodiments disclosed herein are well adapted to attain the ends and advantages mentioned as well as those that are inherent therein. The particular embodiments disclosed above are illustrative only, as the embodiments disclosed may be modified and practiced in different but equivalent manners apparent to those of ordinary skill in the relevant art having the benefit of the teachings herein. Furthermore, no limitations are intended to the details of construction or design herein shown, other than as described in the claims below. It is therefore evident that the particular illustrative embodiments disclosed above may be altered, combined, or modified and all such variations are considered within the scope and spirit of the present disclosure. The embodiments illustratively disclosed herein suitably may be practiced in the absence of any element that is not specifically disclosed herein and/or any optional element disclosed herein. While compositions and methods are described in terms of "comprising," "containing," or "including" various components or steps, the compositions and methods can also "consist essentially of" or "consist of" the various components and steps. All numbers and ranges disclosed above may vary by some number. Whenever a numerical range with a lower limit and an upper limit is disclosed, any number and any included range falling within the range is specifically disclosed. In particular, every range of values (of the form, "from about a to about b," or, equivalently, "from approximately a to b," or, equivalently, "from approximately a-b") disclosed herein is to be understood to set forth every number and range encompassed within the broader range of values. Also, the terms in the claims have their plain, ordinary meaning unless otherwise explicitly and clearly defined by the patentee. Moreover, the indefinite articles "a" or "an," as used in the claims, are defined herein to mean one or more than one of the element that it introduces.

## Claims

1. A three-dimensional heat transfer device (10, 10A, 10D, 10E) configured to be thermally coupled to a heat source, the three-dimensional heat transfer device (10, 10A, 10D, 10E) comprising: a thermally conductive casing (11) having an airtight chamber (S) and a thermal contact surface (113), the thermal contact surface (113) faces away from the airtight chamber (S) and is thermally coupled to the heat source; at least one first heat pipe (12, 12A, 12D, 12E) disposed on the thermally conductive casing (11) and in fluid communication with the airtight chamber (S); and at least one second heat pipe (13, 13A, 13D, 13E) disposed on the thermally conductive casing (11) and in fluid communication with the airtight chamber (S); wherein the first heat pipe (12, 12A, 12D, 12E) and the second heat pipe (13, 13A, 13D, 13E) are configured to guide an airflow to a primary cooling area (M) corresponding to the thermal contact surface (113).

2. The three-dimensional heat transfer device (10, 10A, 10D, 10E) of claim 1, wherein the thermally conductive casing (11) comprises a first shell member (111) and a second shell member (112), the second shell member (112) is disposed on the first shell member (111) such that the first shell member (111) and the second shell member (112) together form the airtight chamber (S), and the first heat pipe (12, 12D) and the second heat pipe (13, 13D) are disposed on the second shell member (112) of the thermally conductive casing (11).

3. The three-dimensional heat transfer device (10, 10D) of claim 1 or 2, wherein a cross-section (121, 121D) of the first heat pipe (12, 12D) is different from a cross-section (131, 131D) of the second heat pipe (13, 13D).

4. The three-dimensional heat transfer device (10, 10D) of one of claims 1 to 3, wherein a size of the cross-section (121, 121D) of the first heat pipe (12, 12D) is different from a size of the cross-section (131, 131D) of the second heat pipe (13, 13D).

5. The three-dimensional heat transfer device (10, 10D) of one of claims 1 to 4, wherein an area of the cross-section (121, 121D) of the first heat pipe (12, 12D) is less than or equal to 80% of an area of the cross-section (131, 131D) of the second heat pipe (13, 13D).

6. The three-dimensional heat transfer device (10, 10D) of one of claims 1 to 3, wherein a shape of the cross-section (121, 121D) of the first heat pipe (12, 12D) can be the same with or different from a shape of the cross-section (131, 131D) of the second heat pipe (13, 13D).

7. The three-dimensional heat transfer device (10) of claim 6, wherein the first heat pipe (12) and the second heat pipe (13) each have an elliptical cross-section (121, 131) with a major axis (R1, R2) corresponding to a longest diameter of the elliptical cross-section and a minor axis (r1, r2) corresponding to a shortest diameter of the elliptical cross-section, and a ratio of the major axis (R1) to the minor axis (r1) of the first heat pipe (12) is different from a ratio of the major axis (R2) to the minor axis (r2) of the second heat pipe (13).

8. The three-dimensional heat transfer device (10, 10D) of claim 6, wherein the shapes of the cross-sections (121, 131, 121D, 131D) of the first heat pipe (12, 12D) or the second heat pipe (13, 13D) are airfoil-shaped, elliptical, or gear-toothed.

9. The three-dimensional heat transfer device (10, 10D) of one of claims 1 to 8, further comprising at least one third heat pipe (14, 14D) disposed on the second shell member (112) and in fluid communication with the airtight chamber (S), wherein a cross-section (141, 141D) of the third heat pipe (14, 14D) is different from the cross-section (121, 121D) of the first heat pipe (12, 12D) and the cross-section (131, 131D) of the second heat pipe (13, 13D).

10. The three-dimensional heat transfer device (10) of claim 9, wherein the third heat pipe (14) is disposed in the primary cooling area (M) corresponding to the thermal contact surface (113), the first heat pipe (12) and the second heat pipe (13) are plural in number and are respectively located on opposite sides of the third heat pipe (14), and the second heat pipes (13) on the same side with the first heat pipes (12), relative to the third heat pipe (14), are disposed between the first heat pipes (12) and the third heat pipe (14).

11. The three-dimensional heat transfer device (10) of claim 9 or 10, wherein each of the first heat pipes (12), the second heat pipes (13), and the at least one third heat pipe (14) has an elliptical cross-section (121, 131, 141) with a major axis (R1, R2, R3) corresponding to a longest diameter and a minor axis (r1, r2, r3) corresponding to a shortest diameter, and wherein a ratio of the major axis (R1) to the minor axis (r1) of the first heat pipes (12) exceeds a ratio of the major axis (R2) to the minor axis (r2) of the second heat pipes (13), and the ratio of the major axis (R2) to the minor axis (r2) of the second heat pipes (13) exceeds a ratio of the major axis (R3) to the minor axis (r3) of the at least one third heat pipe (14).

12. The three-dimensional heat transfer device (10D) of one of claims 1 to 3, further comprising a plurality of third heat pipes (14D), a plurality of fourth heat pipes (15D), and a plurality of fifth heat pipes (16D), wherein the first heat pipes (12D) to the fifth heat pipes (16D) are arranged in sequence, and sizes of cross-sections (121D, 131D, 141D, 151D, 161D) of the first heat pipes (12D) to the fifth heat pipes (16D) gradually increase in sequence.

13. The three-dimensional heat transfer device (10A, 10E) of claim 1 or 2, wherein a cross-section of said at least one first heat pipe (12A, 12E) is identical to a cross-section of said at least one second heat pipe (13A, 13E), the at least one second heat (13A, 13E) pipe is positioned proximate to the primary cooling area (M) to shorten the cooling fluid's circulation path.

14. The three-dimensional heat transfer device (10A, 10E) according to claim 13, wherein the at least one first heat pipe (12A, 12E) and the at least one second heat pipe (13A, 13E) both have substantially the same shape and size.

15. The three-dimensional heat transfer device (10A, 10E) according claim 13 or 14, further comprising at least one third heat pipe (14A, 14E) disposed on the second shell member (112) and in fluid communication with the airtight chamber (S).

16. The three-dimensional heat transfer device (10A, 10E) according to claim 15, wherein the at least one third heat pipe (14A, 14E) is disposed in the primary cooling area (M) corresponding to the thermal contact surface (113), and the first heat pipe (12A, 12E) and the second heat pipe (13A, 13E) are plural in number and are respectively located on opposite sides of the third heat pipe (14A, 14E), and the second heat pipes (13A, 13E) on the same side with the first heat pipes (12A, 12E), relative to the third heat pipe (14A, 14E), are disposed between the first heat pipes (12A, 12E) and the third heat pipe (14A, 14E).

17. The three-dimensional heat transfer device (10A, 10E) according to claim 15 or 16, wherein first heat pipes (12A, 12E), the second heat pipes (13A, 13E) and the at least one third heat pipe (14A, 14E) have substantially the same shape and size.

18. The three-dimensional heat transfer device (10A, 10E) according to one of claims 13 to 17, **characterized in that** the cross-sectional shape of the at least one first heat pipe (12A, 12E) and the at least one second heat pipe (13A, 13E) is an airfoil, an ellipse, a circle, or a gear tooth.
